# EUROPÄISCHE PATENTSCHRIFT

(11) **EP 3 673 290 B1**
(45) Veröffentlichungstag und Bekanntmachung des Hinweises auf die Patenterteilung: **29.11.2023**
(21) Anmeldenummer: 18759247.2
(22) Anmeldetag: 02.08.2018
(51) Int. Cl.: G01S 7/481, B81B 7/00, G01S 17/42, G02B 26/08, G02B 26/12, H01S 5/00, H01S 5/02255, H01S 5/40

(54) **SENDEEINRICHTUNG FÜR EINEN LIDAR-SCANNER MIT EINEM DURCH EIN ABDECKELEMENT ÜBERGEDECKTEN SCANSPIEGEL**
TRANSMITTING DEVICE FOR A LIDAR SCANNER HAVING A SCANNING MIRROR COVERED BY A COVER ELEMENT
DISPOSITIF D'ÉMISSION POUR UN SCANNER LIDAR PRÉSENTANT UN MIROIR DE BALAYAGE RECOUVERT PAR UN ÉLÉMENT DE RECOUVREMENT

(30) Priorität: 21.08.2017 DE 202017105001 U; 13.10.2017 DE 102017123875
(43) Veröffentlichungstag der Anmeldung: 01.07.2020
(73) Patentinhaber: JENOPTIK Optical Systems GmbH, 07745 Jena (DE)
(72) Erfinder: SCHALLER, Uwe, 07768 Kahla (DE); RAABE, Christian, 07743 Jena (DE)
(74) Vertreter: Gleim Petri Patent- und Rechtsanwaltspartnerschaft mbB
(86) Internationale Anmeldenummer: PCT/DE2018/100681
(87) Internationale Veröffentlichungsnummer: WO 2019/037809

(56) Entgegenhaltungen:
- EP-A2- 0 731 417
- EP-A2- 1 480 006
- DE-A1-102011 006 159
- DE-A1-102012 025 281
- JP-A- 2014 186 136
- US-A- 3 899 145
- US-A- 5 321 489

## Beschreibung

Die Erfindung betrifft eine Sendeeinrichtung für einen LIDAR-Scanner, die mit kollimierter Laserstrahlung wenigstens einen Scanwinkelbereich abscannt.

Bei der Entfernungsmessung, bei der einzelne Scanpunkte quasi ins Unendliche abgebildet werden, weisen die einzelnen Scanwinkelbereiche durch das Scannen eines zweidimensionalen Scanfeldes eine dreidimensionale oder durch das Scannen einer eindimensionalen Scanlinie eine zweidimensionale Ausdehnung auf.

Während die Ausdehnung des Scanfeldes bzw. der Scanlinie durch den maximalen Auslenkwinkel des Scanspiegels begrenzt sind, ist dessen Tiefe grundsätzlich zum einen durch das Lambert-Beersche Gesetz, nach dem die Intensität der Strahlung mit dem Laufweg exponentiell abnimmt, bestimmt und durch die geforderte Laserklasse, die die Leistung der Strahlungsquelle begrenzt.

Große Scanwinkelbereiche sind z.B. dort von Interesse, wo ein großer Bereich im Raum lückenlos überwacht werden soll. Einsatzgebiete hierfür können z.B. das Flugwesen, die Schifffahrt, die Militärtechnik oder das autonome Fahren von Straßenfahrzeugen sein.

Mit der Verwendung eines rotierenden Spiegels als Scanspiegel, mit dem große Scanwinkel überstrichen werden können, bedarf es weiterer diskreter Bauteile wie z.B. Halterungen, in denen die Spiegelachse gelagert ist. Die mit der Rotation entstehende Reibung führt zu Verschleiß und dadurch verursachtem Schlupf. Auch sind Baugruppen aus diskreten Bauteilen heutzutage in der Regel aufwendiger in der Herstellung und damit teurer als monolithisch hergestellte Baugruppen. Sie lassen sich auch weniger leicht miniaturisieren und sind in der Regel schwerer.

Völlig verschleißfrei arbeiten MEMS-Spiegel (Mikro-elektromechanisches System), die monolitisch über Festkörpergelenke mit einem Rahmen verbunden sind, wobei zwei um den Mittelpunkt des MEMS-Spiegels um 180° zueinander versetzt angeordnete Festkörpergelenke mechanisch betrachtet eine Drehachse bilden. Es gibt handelsübliche MEMS-Spiegel, die nur um eine Drehachse, die um zwei zueinander senkrechte Drehachsen oder auch um drei oder mehr Gelenke, die einzelne Aufhängungen bilden, ausgelenkt werden können. Der Auslenkwinkel des MEMS-Spiegels gegenüber dem Rahmen ist dabei aufgrund der Festkörpergelenkverbindung jeweils auf ca. +/-10° um eine unausgelenkte Nullstellung begrenzt. Der reibungsfreie Betrieb, seine hohe erreichbare Betriebsfrequenz und der inzwischen vergleichsweise geringe Preis machen MEMS-Spiegel gerade für dynamische kompakte und robuste Geräte sehr attraktiv.

Bei einer Verwendung von MEMS-Spiegeln als Scanspiegel für eine Sendeeinrichtung ist jedoch der begrenzte, kleine Auslenkwinkel von Nachteil. Der maximale Scanwinkelbereich für einen über den MEMS-Spiegel reflektierten Laserstrahl ergibt sich aus dem Vierfachen des maximalen Auslenkwinkels und beträgt somit maximal ca. 40°. Es läge auf der Hand mehrere MEMS-Spiegel zu verwenden, um aus den Scanwinkelbereichen der einzelnen MEMS-Spiegel einen zusammengesetzten größeren Scanwinkelbereich zu erzielen oder um mehrere Scanwinkelbereiche zu schaffen, die voneinander entfernt beabstandet liegen. Dadurch würde jedoch zum einen die Kompaktheit der Vorrichtung leiden und zum anderen müssten technische Maßnahmen getroffen werden, um die MEMS-Spiegel in ihrem Bewegungsablauf zu synchronisieren. Stattdessen mehrere Laserstrahlen unter unterschiedlichen Auftreffwinkel auf einen MEMS-Spiegel zu richten, sodass diese mehrere aneinandergrenzende einzelne Scanwinkelbereiche abscannen die sich zu einem großen Scanwinkelbereich zusammenfügen, hätte den Nachteil, dass ein dem MEMS-Spiegel vorgeordnetes Abdeckelement, welches gemäß dem Stand der Technik nur in Form einer Planplatte bekannt ist, die einzelnen Laserstrahlen unterschiedlich beeinflusst.

Unabhängig davon ob es sich bei dem Scanspiegel um einen MEMS-Spiegel handelt, kann es Gründe geben, dass der Scanspiegel, in einem Gehäuse eingehaust und von einem Abdeckelement überdeckt und somit geschützt ist. Bei dem Abdeckelement handelt es sich hierbei, soweit bekannt, immer um eine zum unausgelenkten Spiegel parallel oder geneigt angeordnete transparente Planplatte.

Ein auf das Abdeckelement auftreffender Laserstrahl, das betrifft gegebenenfalls auch mehrere Laserstrahlen, die auf den Scanspiegel gerichtet werden, und jeden der Laserstrahlen nach der Reflexion am Scanspiegel, erfährt folglich in Abhängigkeit vom Auftreffwinkel auf die Planplatte mehr oder weniger Fresnelsche Verluste, die die Intensität des Laserstrahls ortsabhängig mehr oder weniger verringern. Darüber hinaus kann es zu unerwünschten Reflexen am Abdeckelement kommen.

Aus der DE 10 2012 025 281 A1 ist eine optische Objekterfassungseinheit mit einer Sendeeinheit bekannt, die einen Sender zum Ausstrahlen eines Laserstrahls, einen um seinen Mittelpunkt um eine oder zwei Schwenkrichtungen schwenkbaren Mikrospiegel und eine Sendelinse, die dem Mikrospiegel im Sendestrahlengang, diesen überdeckend, nachgeordnet ist, enthält. Die Sendelinse, ausgeführt als eine Meniskuslinse, kann hier auch als Abdeckung eines Gehäuses der Sendeeinheit fungieren. Nachteilig ist hier, dass der Mikrospiegel nicht für sich allein eingehaust werden kann, da der Laserstrahl zum Mikrospiegel hin nicht über die Sendelinse geführt werden kann.

Aus der DE 10 2011 006 159 A1 ist eine Projektionsvorrichtung mit einem zumindest in zwei Schaltpositionen schwenkbaren MEMS-Spiegel, der von einer Gradientenindexlinse abgedeckt wird, bekannt. Die Gradientenindexlinse ist eine stark positiv brechende Plankonvexlinse bzw. ein stark positiv brechender Meniskus, deren bzw. dessen Planfläche bzw. konkave Fläche dem MEMS-Spiegel zugewandt angeordnet ist. Ein über die Gradientenindexlinse einfallendes, vermutlich paralleles Laserstrahlenbündel wird auf den MEMS-Spiegel fokussiert und nach Reflexion bei erneutem Durchtritt durch die Gradientenindexlinse gegebenenfalls wieder kollimiert. Nachteilig ist zum einen, dass der MEMS-Spiegel, begrenzt durch die Planfläche der Gradientenindexlinse, nur einen sehr kleinen Schwenkbereich aufweist, und zum anderen, dass gegebenenfalls aus unterschiedlichen Auftreffwinkeln kommende Laserstrahlen aufgrund der Brechung an der Planfläche bzw. der konkaven Fläche der Gradientenindexlinse nicht in einem gleichen Punkt auf dem MEMS-Spiegel auftreffen.

Es ist die Aufgabe der Erfindung eine Sendeeinrichtung für einen LIDAR-Scanner, mit einem durch ein Abdeckelement geschützten Scanspiegel zu finden, wobei an dem Abdeckelement höchstens geringe Fresnelsche Verluste und keine unerwünschten Reflexe auftreten.

Die Aufgabe der Erfindung wird mit den Merkmalen des Anspruches 1 gelöst. Vorteilhafte Ausführungen sind in den rückbezogenen Unteransprüchen angegeben.

Die Erfindung soll nachfolgend anhand von Ausführungsbeispielen und Zeichnungen näher erläutert werden.

Hierzu zeigen:
- Fig. 1: eine erstes Ausführungsbeispiel für eine Sendeeinrichtung mit einer Abstrahleinrichtung, die einen vorkollimierten Laserstrahl aussendet,
- Fig. 2: ein zweites Ausführungsbeispiel für eine Sendeeinrichtung mit einer Abstrahleinrichtung, die zwei vorkollimierte einen Winkel miteinander einschließende Laserstrahlen aussendet,
- Fig. 3: ein vereinfachtes Optikschema für den Strahlverlauf eines Laserstrahls in einer erfindungsgemäßen Sendeeinrichtung nach Fig. 1 oder 2,
- Fig. 4a: ein drittes Ausführungsbeispiel für eine erfindungsgemäße Sendeeinrichtung mit einer Abstrahleinrichtung, die zwei vorkollimierte, zueinander parallele Laserstrahlen aussendet,
- Fig. 4b: vergrößerte Teildarstellung einer Sendeeinrichtung nach Fig. 4a,
- Fig. 5: vergrößerte Teildarstellung eines vierten Ausführungsbeispiels für eine Sendeeinrichtung mit einer Abstrahleinrichtung die drei vorkollimierte, zueinander parallele Laserstrahlen entlang einer Reihe aussendet,
- Fig. 6: vergrößerte Teildarstellung eines fünften Ausführungsbeispiels für eine Sendeeinrichtung mit einer Abstrahleinrichtung die drei vorkollimierte, zueinander parallele Laserstrahlen entlang einer Reihe aussendet,
- Fig. 7: vergrößerte Teildarstellung eines sechsten Ausführungsbeispiels für eine Sendeeinrichtung mit einer Abstrahleinrichtung die drei vorkollimierte, zueinander parallele Laserstrahlen entlang einer Reihe aussendet,
- Fig. 8: vergrößerte Teildarstellung eines siebenten Ausführungsbeispiels für eine Sendeeinrichtung mit einer Abstrahleinrichtung die drei vorkollimierte, zueinander parallele Laserstrahlen entlang einer Reihe aussendet und
- Fig. 9: ein vereinfachtes Optikschema für den Strahlverlauf eines Laserstrahls in einer Sendeeinrichtung nach Fig. 4a bis Fig. 8.

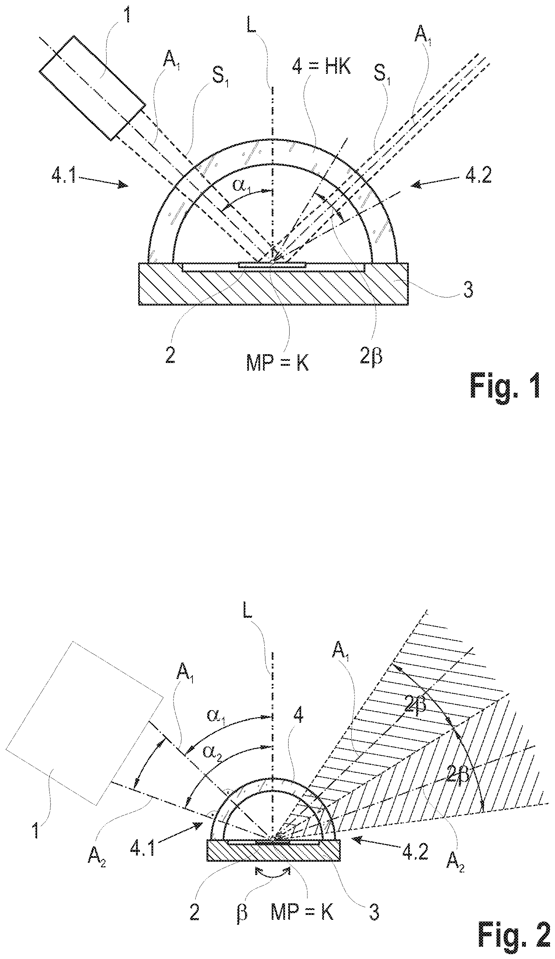

Eine erfindungsgemäße Sendeeinrichtung, umfasst grundsätzlich wie in den **Fig. 1, Fig. 2** oder **Fig. 4a** gezeigt, eine Abstrahleinrichtung 1, die wenigstens einen Laserstrahl S₁,..., Sₙ mit einer Strahlachse A₁,..., Aₙ aussendet und einen um seinen Mittelpunkt MP um einen Auslenkwinkel β auslenkbaren Scanspiegel 2. Der Scanspiegel 2 ist in einem Gehäuse 3 mit einem transparenten Abdeckelement 4 angeordnet. Die Strahlachse A₁,..., Aₙ des wenigstens einen Laserstrahls S₁,..., Sₙ ist so auf das Abdeckelement 4 gerichtet, dass sie, nachdem der wenigstens eine Laserstrahl S₁,..., Sₙ innerhalb eines Einkoppelbereiches 4.1 durch das Abdeckelement 4 getreten ist, auf dem Mittelpunkt MP des Scanspiegels 2 auftrifft. Nach Reflexion des wenigstens einen Laserstrahls S₁,..., Sₙ am Scanspiegel 2 tritt dieser erneut, innerhalb eines Auskoppelbereiches 4.2, durch das Abdeckelement 4 hindurch.

Es ist erfindungswesentlich, dass das Abdeckelement 4 wenigstens im Auskoppelbereich 4.2 durch einen Ausschnitt einer monozentrischen Halbkugelschale HK (nachfolgend nur Halbkugelschale HK) gebildet ist und so den Scanspiegel 2 überdeckend angeordnet ist, dass der Krümmungsmittelpunkt K der Halbkugelschale HK und der Mittelpunkt MP des Scanspiegels 2 zusammenfallen. Monozentrisch heißt die Krümmungsmittelpunkte der beiden Oberflächen der Halbkugelschale HK fallen zusammen.

Das Abdeckelement 4 hat nur die Funktion des Schutzes des Scanspiegels 2 unter Vermeidung unerwünschter optischer Effekte. Indem es zumindest im Abstrahlbereich als Ausschnitt einer monozentrischen Halbkugelschale HK konzipiert ist, hat es eine gleiche Wirkung auf jeden vom Mittelpunkt MP des Scanspiegels 2 in den Abstrahlbereich reflektierten Laserstrahl S₁,..., Sₙ. Der Hauptstrahl eines jeden Laserstrahls S₁,..., Sₙ, der auf den Mittelpunkt MP des Scanspiegels 2 gerichtet wird, wird in Lotrichtung auf die beiden Oberflächen der Halbkugelschale HK reflektiert und läuft daher ungebrochen durch das Abdeckelement 4. Alle anderen Strahlen des Laserstrahls S₁,..., Sₙ (korrekterweise müsste man von einem Laserstrahlenbündel sprechen) werden, da die Halbkugelschale HK zwingend eine gewisse Dicke aufweist, zwangsläufig an den Grenzflächen gebrochen, wobei die Halbkugelschale HK als eine Zerstreuungslinse wirkt. Die nicht vermeidbare optische Wirkung der Halbkugelschale HK wird erfindungsgemäß kompensiert, indem der Laserstrahl S₁,..., Sₙ von der Abstrahleinrichtung 1 bereits vorkollimiert auf das Abdeckelement 4 gerichtet wird. Vorkollimiert heißt hier, der Laserstrahl S₁,..., Sₙ weist eine geringe Konvergenz auf.

Durch die zerstreuende Wirkung der Halbkugelschale HK wird der Laserstahl S₁,..., S_{n_}vollständig kollimiert.

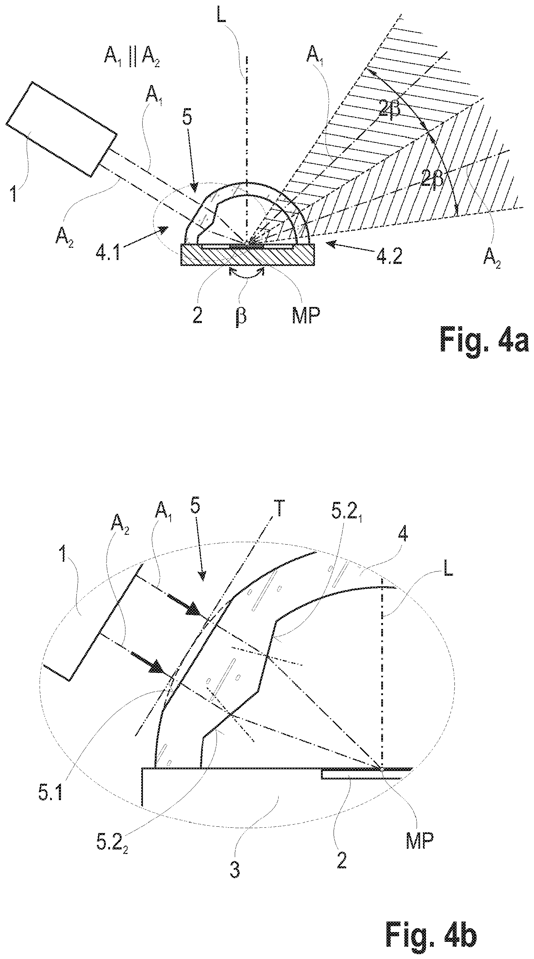

Das Abdeckelement 4 kann eine vollständige Halbkugelschale HK sein, siehe **Fig. 1****,** es kann eine Halbkugelschale HK sein, in der im Einkoppelbereich 4.1 ein Ablenkelement 5 integriert bzw. ausgebildet ist, siehe **Fig. 4a****,** bis dahin, dass die Halbkugelschale HK auf einen den Auskoppelbereich 4.2 umfassenden Ausschnitt reduziert ist und im Einkoppelbereich eine zum unausgelenkten Scanspiegel parallel oder geneigt angeordnete Planplatte darstellt. Grundsätzlich kann das Abdeckelement 4 auch im Einkoppelbereich 4.1 und im Auskoppelbereich 4.2 durch Ausschnitte zweier Halbkugelschalen mit einem unterschiedlichen Radius gebildet werden, wobei die Krümmungsmittelpunkte beider Halbkugelschalen mit dem Mittelpunkt MP des Scanspiegels zusammenfallen. Für die nachfolgende Beschreibung der Erfindung soll vereinfachend davon ausgegangen werden, dass für den Fall, dass sowohl der Einkoppelbereich 4.1 als auch der Auskoppelbereich 4.2 durch einen Ausschnitt einer Halbkugelschale gebildet werden, das Abdeckelement selbst eine vollständige Halbkugelschale ist. Die Halbkugelschale HK hat eine negative Brechkraft. Sie ist durch einen geometrischen Grundkreis definiert, der durch die Umfangslinie der Grundfläche der Halbkugelschale HK beschrieben wird und einen Flächenmittelpunkt aufweist. Der Flächenmittelpunkt stellt gleichzeitig den Krümmungsmittelpunkt K der Halbkugelschale HK und aller Ausschnitte dieser Halbkugelschale HK dar. Das heißt, wird die Halbkugelschale HK auf einen Ausschnitt reduziert, kann auch diesem der gleiche Krümmungsmittelpunkt K zugeordnet werden wie einer gedachten zugeordneten vollständigen Halbkugelschale HK.

Die unterschiedliche Wirkung der verschiedenen Ausführungen des Einkoppelbereiches 4.1 werden später anhand der Ausführungsbeispiele erläutert.

Das Abdeckelement 4 ist zwingend so den Scanspiegel 2 überdeckend angeordnet, dass der Flächenmittelpunkt des geometrischen Grundkreises G auf dem Scanspiegel 2 in dessen Mittelpunkt MP liegt. Fertigungs- und montagebedingte Toleranzen, Langzeitdriften sowie Toleranzabweichungen, die eine erwartungsgemäß sich verschlechternde Strahlqualität in Kauf nehmen, sind hiervon mit umschlossen.

Es ist auch erfindungswesentlich, dass der wenigstens eine Laserstrahl S₁,..., Sₙ, bevor er das Abdeckelement 4 innerhalb des Einkoppelbereiches 3.1 durchtritt, konvergierend vorkollimiert und nach dem erneuten Durchtreten des Abdeckelementes 4 innerhalb des Auskoppelbereiches 3.2 vollständig kollimiert ist.

Es ist fachmännisch, in Kenntnis der Abstrahleigenschaften einer Laserquelle, z.B. einer Laserdiode, einen Kollimator, der gemeinsam mit der Laserquelle die Abstrahleinrichtung 1 für einen Laserstrahl bildet, in Abstimmung mit den optischen Parametern des Abdeckelementes 4 so zu berechnen, dass der von der Sendeeinrichtung ausgesendete Laserstrahl S₁,..., Sₙ vollständig kollimiert ist. Die Abstrahleinrichtung 1 weist, je nachdem wie viele Laserstrahlen S₁,..., Sₙ sie ausstrahlt, Laserquellen 1.1 und Kollimatoren 1.2 auf. Dabei stehen die Laserquellen 1.1 jeweils nahe am, aber nicht genau im objektseitigen Brennpunkt F_{1.2} des zugehörigen Kollimators 1.2, so dass die Laserstrahlen S₁,..., Sₙ beim Austritt aus der Abstrahleinrichtung 1 noch nicht vollständig kollimiert sind.

**Fig. 1** zeigt ein erstes Ausführungsbeispiel für eine Sendeeinrichtung. Die Abstrahleinrichtung 1 strahlt hier genau einen Laserstrahl S₁ ab. In einem zweiten Ausführungsbeispiel, dargestellt in **Fig. 2****,** strahlt die Abstrahleinrichtung 1 zwei Laserstrahlen S₁, S₂ ab. Die Abstrahleinrichtung 1 kann auch mehr als zwei Laserstrahlen (S₁,..., Sₙ) aussenden, deren Strahlachsen (A₁,..., Aₙ) jeweils lotrecht auf die Oberfläche im Einkoppelbereich (4.1) gerichtet sind und einen Winkel miteinander einschließen.

Die Ausführung des Abdeckelementes 4 ist für beide Ausführungsbeispiele gleich und stellt eine vollständige Halbkugelschale HK dar, so dass der Einkoppelbereich 4.1 und der Auskoppelbereich 4.2. des Abdeckelementes 4 jeweils einen Ausschnitt dieser monozentrischen Halbkugelschale HK umfassen. So lässt sich das Abdeckelement 4 vergleichsweise einfach herstellen. Außerhalb des Einkoppelbereiches 4.1 und des Auskoppelbereiches 4.2 kann das Abdeckelement 4 jedoch grundsätzlich jede beliebige geometrische Form aufweisen.

Völlig unabhängig von einem Auftreffwinkel α₁,..., αₙ, unter dem der wenigstens eine Laserstrahl S₁,..., Sₙ gegenüber dem Lot L des unausgelenkten Scanspiegels 4 auf den Scanspiegel 4 auftrifft, trifft dessen Strahlachse A₁, ..., Aₙ nach der Reflexion am Scannspiegel 4, unabhängig von seiner Position während der Auslenkung, immer lotrecht auf das Abdeckelement 4 auf, wenn das Abdeckelement 4 als Halbkugelschale HK ausgebildet ist bzw. wenigstens im Einkoppel- und im Auskoppelbereich 4.1, 4.2 einen Ausschnitt der Halbkugelschale HK darstellt. Dadurch ist der transmittierte Anteil des hindurchtretenden Laserstrahls S₁,..., Sₙ nicht nur größtmöglich, sondern unterliegt bei Auslenkung des Scanspiegels 4 auch keinen Schwankungen.

Vorteilhafterweise wird die Halbkugelschale 4.2, mit einer robusten Wandstärke, z.B. durch Spritzguss hergestellt. Sie hat dann durch ihre Wandstärke auch eine erheblich strahlformende Wirkung.

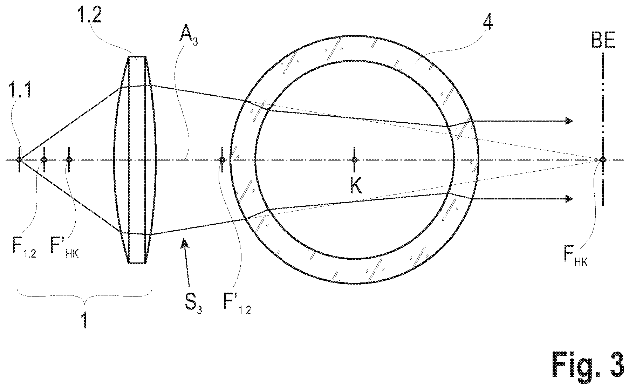

In **Fig. 3** ist ein vereinfachtes aufgeklapptes Optikschema für den erfindungsgemäßen Strahlverlauf der Laserstrahlen S₁,..., Sₙ anhand eines Laserstrahls S₃ für das erste und zweite Ausführungsbeispiel einer Sendeeinrichtung dargestellt. Aufgeklappt heißt hier, dass eine Strahlumlenkung durch die Reflexion am Scanspiegel 2 unbeachtet bleibt. Ein von der Abstrahleinrichtung 1 kommender vorkollimierter Laserstrahl S₃ wird durch das zweifache Durchtreten der Halbkugelschale HK, die eine negative Brechkraft F_{HK}, F'_{HK} aufweist, vollständig kollimiert. Eine vollständige Kollimation für den Laserstrahl S₃ wird erreicht, indem der Kollimator 1.2 so ausgelegt ist, dass die Laserstrahlquelle 1.1 über den Kollimator 1.2 in eine Bildebene BE abgebildet wird, die durch den Ort des objektseitigen Brennpunktes F_{HK} der Halbkugelschale HK verläuft.

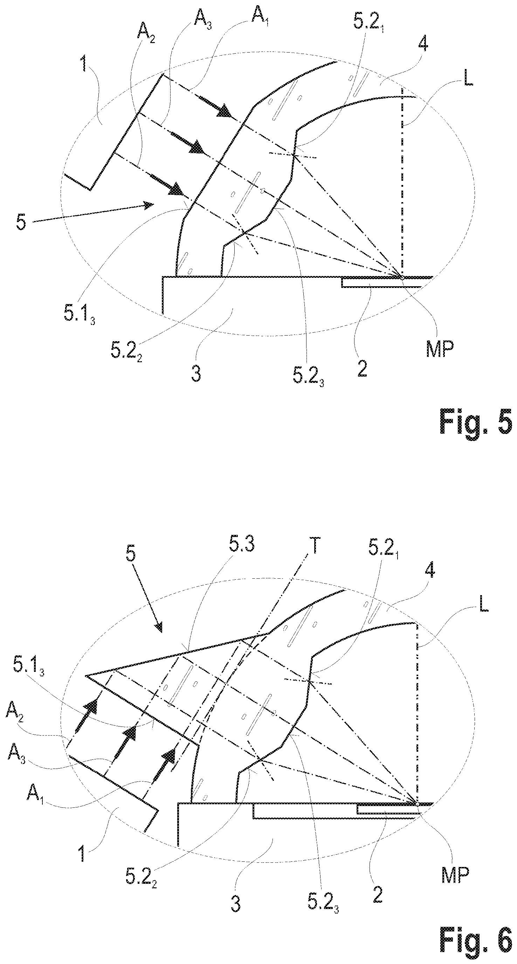

In **Fig. 4a** ist eine Prinzipskizze für ein drittes Ausführungsbeispiel für eine erfindungsgemäße Sendeeinrichtung dargestellt, von dem in **Fig. 4b** ein vergrößerter Ausschnitt das Ablenkelement 4 zeigt. In den **Fig. 5** bis **Fig. 8** sind für weitere Ausführungsbeispiele ein jeweils unterschiedlich ausgeführtes Ablenkelement 4 gezeigt. Diese Ausführungsbeispiele unterscheiden sich gegenüber den beiden erst genannten Ausführungsbeispielen dadurch, dass die Abstrahleinrichtung 1 wenigstens zwei Laserstrahlen S₁,..., Sₙ, mit zueinander parallel ausgerichteten Strahlachsen A₁,..., Aₙ aussendet und dass das Abdeckelement 4 im Einkoppelbereich 4.1 ein Ablenkelement 5 umfasst oder als ein solches ausgebildet ist, über das die wenigstens zwei Laserstrahlen S₁,..., Sₙ auf den Mittelpunkt MP gelenkt werden.

Gemäß dem dritten Ausführungsbeispiel nach den **Fig. 4a** und **Fig. 4b** und dem vierten Ausführungsbeispiel nach **Fig. 5** weißt das Ablenkelement 5 eine plane Eintrittsfläche 5.1₃ auf, die in einer gedachten Tangentialebene T oder parallel zu einer gedachten Tangentialebene T der Halbkugelschale HK angeordnet ist und eine gleiche Anzahl von planen, zueinander geneigten Austrittsflächen 5.2₁,..., 5.2ₙ, wie die Abstrahleinrichtung 1 Laserstrahlen S₁,..., Sₙ aussendet, sodass die wenigstens zwei parallelen Laserstrahlen S₁,..., Sₙ, ausgenommen einen der Laserstrahlen S₁,..., Sₙ, bei lotrechter Ausrichtung zu der Eintrittsfläche 5.1₃ jeweils über die Brechung an den Austrittsflächen 5.2₁,..., 5.2ₙ auf den Mittelpunkt MP gelenkt werden.

Vorteilhaft sendet die Abstrahleinrichtung 1 eine ungerade Anzahl von Laserstrahlen S₁,..., Sₙ aus, wie in dem vierten Ausführungsbeispiel, in **Fig. 5** dargestellt, und die Austrittsflächen 5.2₁,..., 5.2ₙ sind in einer Reihe angeordnet, wobei eine mittlere der Austrittsflächen 5.2₁,..., 5.2ₙ parallel zu der einen Eintrittsfläche 5.1₃ und die weiteren der Austrittsflächen 5.2₁,..., 5.2ₙ symmetrisch zu der mittleren der Austrittsflächen 5.2₁,..., 5.2ₙ angeordnet sind, sodass sich jeweils zwei der weiteren der Austrittsflächen 5.2₁,..., 5.2ₙ symmetrisch gegenüberliegen und jeweils einen gleichen Winkel mit der mittleren der Austrittsflächen 5.2₁,..., 5.2ₙ einschließen.

Ein fünftes Ausführungsbeispiel, dargestellt in **Fig. 6****,** unterscheidet sich gegenüber dem dritten und vierten Ausführungsbeispiel dadurch, dass die eine plane Eintrittsfläche 5.1₃ senkrecht zu einer gedachten Tangentialebene T der Halbkugelschale HK angeordnet ist und eine Rückfläche 5.3 aufweist, die zur Eintrittsfläche 5.1 um 45° geneigt ist, so dass die wenigstens zwei Laserstrahlen S₁,..., Sₙ bei lotrechter Ausrichtung deren Strahlachsen A₁,..., Aₙ zur Eintrittsfläche 5.1₃, von der Rückfläche 5.3 reflektiert und jeweils über die Brechung an den Austrittsflächen 5.2₁,..., 5.2ₙ auf den Mittelpunkt MP gelenkt werden.

Die eine Eintrittsfläche 5.1₃ kann auch einen anderen Winkel mit der gedachten Tangentialebene T zwischen 0° und 90° einschließen, so dass die Abstrahleinrichtung 1 in ihrer Relativlage zum Scanspiegel 2 je nach gegebener Baufreiheit angeordnet sein kann.

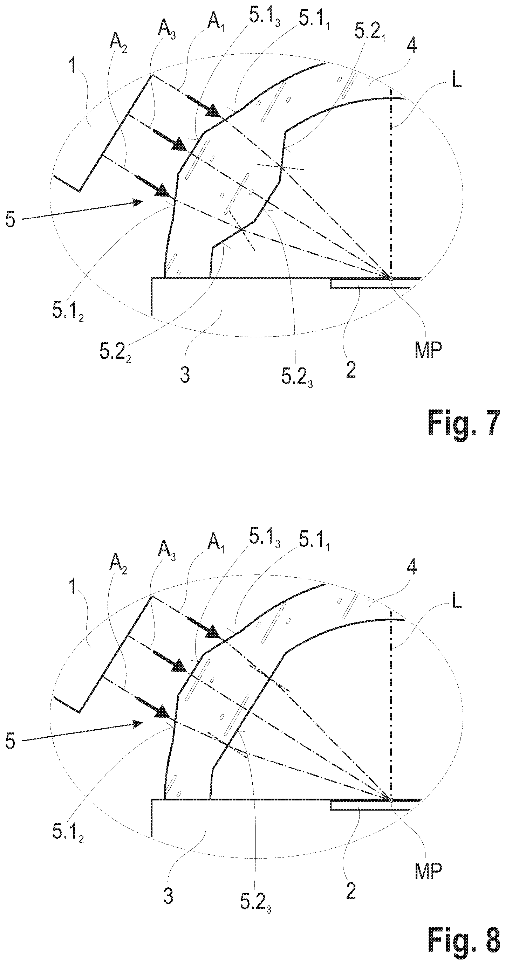

Das in **Fig. 7** gezeigte sechste Ausführungsbeispiel unterscheidet sich gegenüber dem dritten bis fünften dadurch, dass das Ablenkelement 5 eine gleiche Anzahl von Eintrittsflächen 5.1₁,..., 5.1ₙ aufweist wie die Abstrahleinrichtung 1 Laserstrahlen S₁,..., Sₙ aussendet.

Das in **Fig. 8** gezeigte siebente Ausführungsbeispiel unterscheidet sich gegenüber dem sechsten Ausführungsbeispiel dadurch, dass das Ablenkelement 5 nur eine Austrittsfläche 5.2₃ aufweist.

Die beiden letztgenannten Ausführungen für ein Ablenkelement 5 sind besonders vorteilhaft, da die Brechung für die Laserstrahlen S₁,..., Sₙ auf zwei Flächen aufgeteilt werden kann.

Alle vorgenannten Ausführungen des Ablenkelementes 5 bilden für die einzelnen Laserstrahlen S₁,..., S_{n,}, jeweils einen Keil, indem die jeweils zugeordnete Eintrittsfläche 5.1₁,..., 5.1ₙ und die jeweils zugeordnete Austrittsfläche 5.2₁,..., 5.2ₙ zueinander geneigt angeordnet sind. Für einen der Laserstrahlen S₃ kann das Ablenkelement eine Planplatte sein mit der Eintrittsfläche 5.1₃ parallel zu der Austrittsfläche 5.2s.

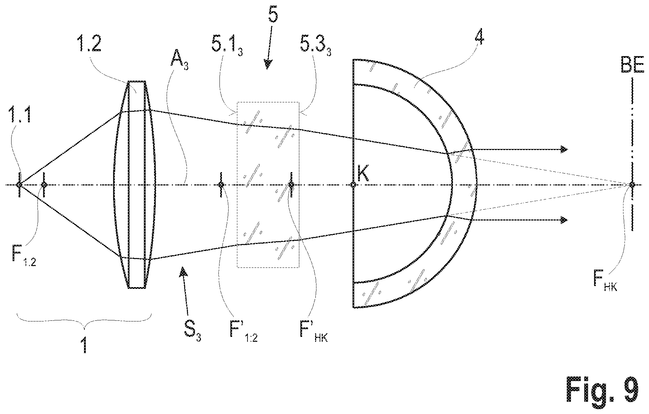

In **Fig. 9** ist ein vereinfachtes aufgeklapptes Optikschema für den Strahlverlauf der Laserstrahlen S₁,..., Sₙ anhand eines Laserstrahls S₃ für das dritte bis siebente Ausführungsbeispiel dargestellt. Aufgeklappt heißt hier, dass die Strahlumlenkung durch Reflexion am Scanspiegel 2 und durch Brechung bzw. Brechung und Reflexion im Ablenkelement 5 nicht beachtet wird. Ein von der Abstrahleinrichtung 1 kommender vorkollimierter Laserstrahl S₁,..., Sₙ wird in Abhängigkeit von der Neigung seiner Strahlachse A₁,..., Aₙ beim Durchtritt des Ablenkelementes 5 unterschiedlich gebrochen und damit umgelenkt. Stellvertretend ist in Fig. 9 der Strahlverlauf des Laserstrahls S₃ dargestellt, für den das Ablenkelement 5 nur als Planplatte wirkt. Das Ablenkelement 5 wirkt nicht abbildend, so dass die vollständige Kollimierung des vorkollimierten Laserstrahls durch die einfache Abbildung über die Halbkugelschale HK erfolgt.

Die vollständige Kollimation für den Laserstrahl S₃ wird dann erreicht, indem der Kollimator 1.2 so ausgelegt ist, dass die Laserstrahlquelle 1.1 über den Kollimator 1.2 und das Ablenkelement 5 in eine Bildebene BE abgebildet wird, die durch den Ort des objektseitigen Brennpunktes F_{HK} der Halbkugelschale HK verläuft.

Das Ablenkelement 5 kann als diskret gefertigtes Bauteil in das Abdeckelement 4 eingesetzt sein oder ist vorteilhaft monolithisch in dem Abdeckelement 4 ausgebildet.

Das erste und zweite Ausführungsbeispiel gehören zu einem ersten Typ einer erfindungsgemäßen Sendeeinrichtung, bei dem im Unterschied zu einem zweiten Typ ein gleiches Abdeckelement 4 unabhängig von der Anzahl der Laserstrahlen und von dem Winkel den diese miteinander einschließen verwendet werden kann.

Das dritte, vierten und fünfte Ausführungsbeispiel gehören zu dem zweiten Typ einer erfindungsgemäßen Sendeeinrichtung. Im Unterschied zum ersten Typ können hier für die Abstrahleinrichtung 1 handelsübliche Laserdiodenarrays, beim dem alle Laserdiodenelemente die in einer gleichen Richtung abstrahlen, verwendet werden.

### Bezugszeichenliste

- 1: Abstrahleinrichtung
- 1.1: Laserstrahlquelle
- 1.2: Kollimator
- 2: Scanspiegel
- 3: Gehäuse
- 4: Abdeckelement
- 4.1: Einkoppelbereich ( des Abdeckelements 4)
- 4.2: Auskoppelbereich (des Abdeckelements 4)
- 5: Ablenkelement
- 5.1₁,..., 5.1ₙ: Eintrittsfläche (des Ablenkelements 5)
- 5.2₁,..., 5.2ₙ: Austrittsfläche (des Ablenkelements 5)
- 5.3: Rückfläche (des Ablenkelements 5)

- S₁,..., Sₙ: Laserstrahl
- A₁,..., Aₙ: Strahlachse (des Laserstrahls S₁,..., Sₙ)
- MP: Mittelpunkt (des Scanspiegels 2)
- T: gedachte Tangentialebene
- L: Lot
- HK: monozentrische Halbkugelschale
- K: Krümmungsmittelpunkt (der monozentrischen Halbkugelschale HK)
- α₁,..., αₙ: Auftreffwinkel
- β: Auslenkwinkel (des Scanspiegels 2)
- F_{1.2}: objektseitiger Brennpunkt des Kollimators
- F'_{1.2}: bildseitiger Brennpunkt des Kollimators
- BE: Bildebene
- F_{HK}: objektseitiger Brennpunkt der Halbkugelschale
- F'_{HK}: bildseitiger Brennpunkt der Halbkugelschale

## Patentansprüche

1. Sendeeinrichtung, enthaltend eine Abstrahleinrichtung (1), die wenigstens einen Laserstrahl (S₁,..., Sₙ) mit einer Strahlachse (A₁,..., Aₙ) aussendet und einen um seinen Mittelpunkt (MP) auslenkbaren Scanspiegel (2), der innerhalb eines Gehäuses (3) mit einem transparenten Abdeckelement (4) angeordnet ist, wobei die Strahlachse (A₁,..., Aₙ) des wenigstens einen Laserstrahls (S₁,..., Sₙ) so auf das Abdeckelement (4) gerichtet ist, dass sie nach Durchtritt des wenigstens einen Laserstrahls (S₁,..., Sₙ) durch das Abdeckelement (4) innerhalb eines Einkoppelbereiches (4.1) auf dem Mittelpunkt (MP) auftrifft und der wenigstens eine Laserstrahl (S₁,..., Sₙ) nach Reflexion am Scanspiegel (2) das Abdeckelement (4) erneut, innerhalb eines Auskoppelbereiches (4.2) durchtritt, **dadurch gekennzeichnet,**
**dass** das Abdeckelement (4) wenigstens im Auskoppelbereich (4.2) durch einen Ausschnitt einer monozentrischen Halbkugelschale (HK) gebildet ist, wobei die monozentrische Halbkugelschale (HK) einen Krümmungsmittelpunkt (K), in dem die Krümmungsmittelpunkte der beiden Oberflächen der Halbkugelschale (HK) zusammenfallen, und eine negative Brechkraft aufweist,
**dass** das Abdeckelement (4) so den Scanspiegel (2) überdeckend angeordnet ist, dass der Krümmungsmittelpunkt (K) und der Mittelpunkt (MP) des Scanspiegels (2) zusammenfallen, so dass das Abdeckelement (4) eine gleiche Wirkung auf jeden vom Mittelpunkt (MP) des Scanspiegels (2) in den Auskoppelbereich (4.2) reflektierten Laserstrahl (S₁, ..., Sₙ) hat, und
**dass** der wenigstens eine Laserstrahl (S₁,..., Sₙ) vor dem Durchtritt durch das Abdeckelement (4) innerhalb des Einkoppelbereiches (4.1), konvergierend vorkollimiert und nach dem erneuten Durchtritt durch das Abdeckelement (4) innerhalb des Auskoppelbereiches (4.2) vollständig kollimiert ist, indem eine Laserstrahlquelle (1.1) über einen Kollimator (1.2) in eine Bildebene (BE) abgebildet wird, die durch den Ort eines objektseitigen Brennpunktes (F_{HK}) der Halbkugelschale (HK) verläuft.

2. Sendeeinrichtung nach Anspruch 1, **dadurch gekennzeichnet,**
**dass** das Abdeckelement (4) im Einkoppelbereich (4.1) durch einen zweiten Ausschnitt der monozentrischen Halbkugelschale (HK) oder einen Ausschnitt einer weiteren monozentrischen Halbkugelschale gebildet ist, wobei der Krümmungsmittelpunkt (K) der monozentrischen Halbkugelschale (HK) und der Krümmungsmittelpunkt der weiteren monozentrischen Halbkugelschale zusammenfallen.

3. Sendeeinrichtung nach Anspruch 2, **dadurch gekennzeichnet,**
**dass** das Abdeckelement (4) die vollständige monozentrische Halbkugelschale (HK) ist.

4. Sendeeinrichtung nach Anspruch 2 oder 3, **dadurch gekennzeichnet,**
**dass** die Abstrahleinrichtung (1) wenigstens zwei Laserstrahlen (S₁,..., Sₙ) mit zueinander, jeweils einen Winkel miteinander einschließend, ausgerichteten Strahlachsen (A₁,..., Aₙ) aussendet, die jeweils lotrecht auf eine Oberfläche des Abdeckelementes (4) im Einkoppelbereich (4.1) gerichtet sind.

5. Sendeeinrichtung nach Anspruch 1, **dadurch gekennzeichnet,**
**dass** in dem Abdeckelement (4) im Einkoppelbereich (4.1) ein Ablenkelement (5) als diskret gefertigtes Bauteil eingesetzt oder monolithisch ausgebildet ist, über das der wenigstens eine Laserstrahl (S₁,..., Sₙ) auf den Mittelpunkt (MP) gelenkt wird.

6. Sendeeinrichtung nach Anspruch 5, **dadurch gekennzeichnet,**
**dass** die Abstrahleinrichtung (1) wenigstens zwei Laserstrahlen (S₁,..., Sₙ) mit zueinander parallel ausgerichteten Strahlachsen (A₁, ..., Aₙ) aussendet und das Ablenkelement (5) eine plane Eintrittsfläche (5.1₃), die in einer gedachten Tangentialebene (T) oder parallel zu einer gedachten Tangentialebene (T) der monozentrischen Halbkugelschale (HK) angeordnet ist und eine gleiche Anzahl von planen, zueinander geneigten Austrittsflächen (5.2₁,..., 5.2ₙ) aufweist, wie die Abstrahleinrichtung (1) Laserstrahlen (S₁, ..., Sₙ) aussendet, sodass die wenigstens zwei Laserstrahlen (S₁, ..., Sₙ) bei lotrechter Ausrichtung zur Eintrittsfläche (5.1₃) jeweils über die Brechung an den Austrittsflächen (5.2₁, ..., 5.2ₙ) auf den Mittelpunkt (MP) gelenkt werden.

7. Sendeeinrichtung nach Anspruch 5, **dadurch gekennzeichnet,**
**dass** die Abstrahleinrichtung (1) wenigstens zwei Laserstrahlen (S₁, ..., Sₙ) mit zueinander parallel ausgerichteten Strahlachsen (A₁, ..., Aₙ) aussendet und das Ablenkelement (5) eine plane Austrittsfläche (5.2s) aufweist, die in einer gedachten Tangentialebene (T) oder parallel zu einer gedachten Tangentialebene (T) der monozentrischen Halbkugelschale (HK) angeordnet ist und dass das Ablenkelement (5) eine gleiche Anzahl von planen, zueinander geneigten Eintrittsflächen (5.1₁, ..., 5.1ₙ) aufweist, wie die Abstrahleinrichtung (1) Laserstrahlen (S₁, ..., Sₙ) aussendet, sodass die wenigstens zwei Laserstrahlen (S₁, ..., Sₙ) bei lotrechter Ausrichtung zur Austrittsfläche (5.2s) jeweils über die Brechung an den Eintrittsflächen (5.1₁, ..., 5.1ₙ) und Austrittsfläche (5.2s) auf den Mittelpunkt (MP) gelenkt werden.

8. Sendeeinrichtung nach Anspruch 6, **dadurch gekennzeichnet,**
**dass** die Abstrahleinrichtung (1) eine ungerade Anzahl von Laserstrahlen (S₁,..., Sₙ) aussendet und die Austrittsflächen (5.2₁,..., 5.2ₙ) in einer Reihe angeordnet sind, wobei eine mittlere der Austrittsflächen (5.2₁,..., 5.2ₙ) parallel zur Eintrittsfläche (5.1) und weitere der Austrittsflächen (5.2₁,..., 5.2ₙ) symmetrisch zu der mittleren der Austrittsflächen (5.2₁,..., 5.2ₙ) angeordnet sind, sodass sich jeweils zwei der weiteren der Austrittsflächen (5.2₁,..., 5.2ₙ) symmetrisch gegenüberliegen und jeweils einen gleichen Winkel mit der mittleren der Austrittsflächen (5.2₁,..., 5.2ₙ) einschließen.

9. Sendeeinrichtung nach Anspruch 5, **dadurch gekennzeichnet,**
**dass** die Abstrahleinrichtung (1) wenigstens zwei Laserstrahlen (S₁,..., Sₙ) mit zueinander parallel ausgerichteten Strahlachsen (A₁,..., Aₙ) aussendet und das Ablenkelement (5) eine plane Eintrittsfläche (5.1₃), die senkrecht zu einer gedachten Tangentialebene (T) der monozentrischen Halbkugelschale (HK) angeordnet ist, eine Rückfläche (5.3) und eine gleiche Anzahl von planen, zueinander geneigten Austrittsflächen (5.2₁,..., 5.2ₙ) aufweist, wie die Abstrahleinrichtung (1) Laserstrahlen (S₁,..., Sₙ) aussendet, sodass die wenigstens zwei Laserstrahlen (S₁,..., Sₙ) bei lotrechter Ausrichtung zur Eintrittsfläche (5.1₃), von der Rückfläche (5.3) reflektiert und jeweils über die Brechung an den Austrittsflächen (5.2₁,..., 5.2ₙ) auf den Mittelpunkt (MP) gelenkt werden.

10. Sendeeinrichtung nach einem der Ansprüche 5 bis 9, **dadurch gekennzeichnet, dass** das Ablenkelement (5) monolithisch in dem Abdeckelement (4) ausgebildet ist.

## Claims

1. A transmitting device, containing an emitting device (1), which emits at least one laser beam (S₁,..., Sₙ) with a beam axis (A₁,..., Aₙ), and a scanning mirror (2) which can be deflected about its centre (MP) and is arranged inside a housing (3) with a transparent cover element (4), wherein the beam axis (A₁,..., Aₙ) of the at least one laser beam (S₁,..., Sₙ) is directed at the cover element (4) in such a way that, after passage of the at least one laser beam (S₁,..., Sₙ) through the cover element (4) within a coupling-in region (4.1), it impinges on the centre (MP), and the at least one laser beam (S₁,..., Sₙ), after reflection at the scanning mirror (2), passes through the cover element (4) again within a coupling-out region (4.2), **characterized in that**
the cover element (4) is formed, at least in the coupling-out region (4.2), by a section of a monocentric hemispherical shell (HK), the monocentric hemispherical shell (HK) having a centre of curvature (K), in which the centres of curvature of both surfaces of the hemispherical shell (HK) coincide, and having negative refractive power,
the cover element (4) is arranged to cover the scanning mirror (2) so that the centre of curvature (K) and the centre (MP) of the scanning mirror (2) coincide, so that the cover element (4) has an equal effect on each laser beam (S₁, ..., Sₙ) reflected from the centre (MP) of the scanning mirror (2) into the coupling-out region (4.2), and
the at least one laser beam (S₁,..., Sₙ) is convergingly pre-collimated before passing through the cover element (4) within the coupling-in region (4.1) and is fully collimated within the coupling-out region (4.2) after passing through the cover element (4) again, by imaging a laser beam source (1.1) into an image plane (BE), which passes through an object-side focal point (F_{HK}) of the hemispherical shell (HK), via a collimator (1.2).

2. The transmitting device according to claim 1, **characterized in that**
the cover element (4) is formed in the coupling-in region (4.1) by a second section of the monocentric hemispherical shell (HK) or a section of a further monocentric hemispherical shell, the centre of curvature (K) of the monocentric hemispherical shell (HK) and the centre of curvature of the further monocentric hemispherical shell coinciding.

3. The transmitting device according to claim 2, **characterized in that**
the cover element (4) is the complete monocentric hemispherical shell (HK).

4. The transmitting device according to claim 2 or 3, **characterized in that**
the emitting device (1) emits at least two laser beams (S₁,..., Sₙ) with beam axes (A₁,..., Aₙ) aligned with each other so as to enclose an angle with each other, which are each directed perpendicular to a surface of the cover element (4) in the coupling-in region (4.1).

5. The transmitting device according to claim 1, **characterized in that**
a deflecting element (5) is arranged as a discretely manufactured component in the cover element (4) in the coupling-in region (4.1) or is monolithically formed therein, via which deflecting element (5) the at least one laser beam (S₁,..., Sₙ) is directed at the centre (MP).

6. The transmitting device according to claim 5, **characterized in that**
the emitting device (1) emits at least two laser beams (S₁,..., Sₙ) with parallel beam axes (A₁,..., Aₙ) and the deflecting element (5) has a planar entrance surface (5.1₃), which is arranged in an imaginary tangential plane (T) or parallel to an imaginary tangential plane (T) of the monocentric hemispherical shell (HK) and has an equal number of planar, mutually inclined exit surfaces (5.2₁,..., 5.2ₙ) as the emitting device (1) emits laser beams (S₁,..., Sₙ), so that the at least two laser beams (S₁,..., Sₙ), when aligned perpendicularly to the entrance surface (5.1₃), are each directed at the centre (MP) via refraction at the exit surfaces (5.2₁,..., 5.2ₙ).

7. The transmitting device according to claim 5, **characterized in that**
the emitting device (1) emits at least two laser beams (S₁,..., Sₙ) with parallel beam axes (A₁,..., Aₙ) and the deflecting element (5) has a planar exit surface (5.2₃), which is arranged in an imaginary tangential plane (T) or parallel to an imaginary tangential plane (T) of the monocentric hemispherical shell (HK) and that the deflecting element (5) has an equal number of planar, mutually inclined entrance surfaces (5.1₁,..., 5.1ₙ) as the emitting device (1) emits laser beams (S₁,..., Sₙ), so that the at least two laser beams (S₁,..., Sₙ), when aligned perpendicularly to the exit surface (5.2₃), are each directed at the centre (MP) via refraction at the entrance surfaces (5.1₁,..., 5.1ₙ) and exit surface (5.2s).

8. The transmitting device according to claim 6, **characterized in that**
the emitting device (1) emits an odd number of laser beams (S₁,..., Sₙ), and the exit surfaces (5.2₁,..., 5.2ₙ) are arranged in a row, where a middle one of the exit surfaces (5.2₁,..., 5.2ₙ) is parallel to the entrance surface (5.1) and further ones of the exit surfaces (5.2₁,..., 5.2ₙ) are arranged symmetrically to the middle one of the exit surfaces (5.2₁,..., 5.2ₙ), so that two of the further ones of the exit surfaces (5.2₁,..., 5.2ₙ) are symmetrically opposite each other and each enclose an equal angle with the middle one of the exit surfaces (5.2₁,..., 5.2ₙ).

9. The transmitting device according to claim 5, **characterized in that**
the emitting device (1) emits at least two laser beams (S₁,..., Sₙ) with parallel beam axes (A₁,..., Aₙ) and the deflecting element (5) has a planar entrance surface (5.13s), which is arranged perpendicular to an imaginary tangential plane (T) of the monocentric hemispherical shell (HK), has a rear surface (5.3) and an equal number of planar, mutually inclined exit surfaces (5.2₁,..., 5.2ₙ) as the emitting device (1) emits laser beams (S₁,..., Sₙ), so that the at least two laser beams (S₁,..., Sₙ), when aligned perpendicularly to the entrance surface (5.1₃), are reflected by the rear surface (5.3) and are each directed at the centre (MP) via refraction at the exit surfaces (5.2₁,..., 5.2ₙ).

10. The transmitting device according to any one of claims 5 to 9, **characterized in that** the deflecting element (5) is monolithically formed in the cover element (4).

## Revendications

1. Dispositif d'émission, comprenant un dispositif de rayonnement (1), qui émet au moins un faisceau laser (S₁,..., Sₙ) avec un axe de faisceau (A₁,..., Aₙ), et un miroir de balayage (2) pouvant être dévié autour de son centre (MP) et étant disposé à l'intérieur d'un boîtier (3) avec un élément de recouvrement transparent (4), l'axe de faisceau (A₁,..., Aₙ) dudit au moins un faisceau laser (S₁,..., Sₙ) étant dirigé sur l'élément de recouvrement (4) de telle sorte qu'après le passage dudit au moins un faisceau laser (S₁,..., Sₙ) à travers l'élément de recouvrement (4), il rencontre le point central (MP) à l'intérieur d'une zone de couplage (4.1) et que ledit au moins un faisceau laser (S₁,..., Sₙ), après réflexion sur le miroir de balayage (2), traverse à nouveau l'élément de recouvrement (4) à l'intérieur d'une zone de découplage (4.2), **caractérisé en ce que**
l'élément de recouvrement (4) est formé, au moins dans la zone de découplage (4.2), par une découpe d'une coque hémisphérique monocentrique (HK), la coque hémisphérique monocentrique (HK) présentant un centre de courbure (K), dans lequel les centres de courbure des deux surfaces de la coque hémisphérique (HK) coïncident, et une puissance réfractive négative,
l'élément de recouvrement (4) est disposé de manière à recouvrir le miroir de balayage (2) de telle sorte que le centre de courbure (K) et le centre (MP) du miroir de balayage (2) coïncident, de sorte que l'élément de recouvrement (4) a un effet égal sur chaque faisceau laser (S₁,..., Sₙ) réfléchi par le centre (MP) du miroir de balayage (2) dans la zone de découplage (4.2), et
ledit au moins un faisceau laser (S₁,..., Sₙ) est précollimaté de manière convergente avant le passage à travers l'élément de recouvrement (4) à l'intérieur de la zone de couplage (4.1) et qu'il est complètement collimaté après le nouveau passage à travers l'élément de recouvrement (4) à l'intérieur de la zone de découplage (4.2), par le fait qu'une source de faisceau laser (1.1) est reproduite par l'intermédiaire d'un collimateur (1.2) dans un plan d'image (BE) qui passe par l'emplacement d'un point focal (F_{HK}) côté objet de la coque hémisphérique (HK).

2. Dispositif d'émission selon la revendication 1, **caractérisé en ce que**
l'élément de recouvrement (4) est formé dans la zone de couplage (4.1) par une deuxième découpe de la coque hémisphérique monocentrique (HK) ou par une découpe d'une autre coque hémisphérique monocentrique, le centre de courbure (K) de la coque hémisphérique monocentrique (HK) et le centre de courbure de l'autre coque hémisphérique monocentrique coïncidant.

3. Dispositif d'émission selon la revendication 2, **caractérisé en ce que**
l'élément de recouvrement (4) est la coque hémisphérique monocentrique complète (HK).

4. Dispositif d'émission selon la revendication 2 ou 3, **caractérisé en ce que**
le dispositif de rayonnement (1) émet au moins deux faisceaux laser (S₁,..., Sₙ) avec des axes de faisceau (A₁,..., Aₙ) orientés l'un par rapport à l'autre, en formant respectivement un angle entre eux, qui sont dirigés respectivement perpendiculairement sur une surface de l'élément de recouvrement (4) dans la zone de couplage (4.1).

5. Dispositif d'émission selon la revendication 1, **caractérisé en ce que**,
dans l'élément de recouvrement (4), dans la zone de couplage (4.1), un élément de déviation (5) est inséré sous la forme d'un composant fabriqué de manière discrète ou est réalisé de manière monolithique, par l'intermédiaire duquel ledit au moins un faisceau laser (S₁,..., Sₙ) est dirigé sur le point central (MP).

6. Dispositif d'émission selon la revendication 5, **caractérisé en ce que** le dispositif de rayonnement (1) émet au moins deux faisceaux laser (S₁,..., Sₙ) avec des axes de faisceau (A₁,..., Aₙ) orientés parallèlement les uns aux autres et **en ce que** l'élément de déviation (5) présente une surface d'entrée plane (5.1₃) qui est disposée dans un plan tangentiel imaginaire (T) ou parallèlement à un plan tangentiel imaginaire (T) de la coque hémisphérique monocentrique (HK) et présente un nombre de surfaces de sortie planes (5.2₁, ..., 5.2ₙ), inclinées les unes par rapport aux autres, qui est égal au nombre de faisceaux laser (S₁,..., Sₙ) émis par le dispositif de rayonnement (1), de sorte que les au moins deux faisceaux laser (S₁,..., Sₙ), lorsqu'ils sont orientés perpendiculairement à la surface d'entrée (5.1s), sont respectivement dirigés vers le centre (MP) par l'intermédiaire de la réfraction sur les surfaces de sortie (5.2₁, ..., 5.2ₙ).

7. Dispositif d'émission selon la revendication 5, **caractérisé en ce que**
le dispositif de rayonnement (1) émet au moins deux faisceaux laser (S₁,..., Sₙ) avec des axes de faisceau (A1, ..., An) orientés parallèlement l'un à l'autre et que l'élément de déviation (5) présente une surface de sortie plane (5.2s) qui est disposée dans un plan tangentiel imaginaire (T) ou parallèlement à un plan tangentiel imaginaire (T) de la coque hémisphérique monocentrique (HK) et que l'élément de déviation (5) présente un nombre de surfaces d'entrée planes (5.1₁, ..., 5.1ₙ), inclinées les unes par rapport aux autres, qui est égal au nombre de faisceaux laser (S₁,..., Sₙ) émis par le dispositif de rayonnement (1), de sorte que les au moins deux faisceaux laser (S₁,..., Sₙ), lorsqu'ils sont orientés perpendiculairement à la surface de sortie (5.2s), sont respectivement dirigés sur le point central (MP) par l'intermédiaire de la réfraction sur les surfaces d'entrée (5.1₁, ..., 5.1ₙ) et la surface de sortie (5.2s).

8. Dispositif d'émission selon la revendication 6, **caractérisé en ce que**
le dispositif de rayonnement (1) émet un nombre impair de faisceaux laser (S₁,..., Sₙ) et que les surfaces de sortie (5.2₁,..., 5.2ₙ) sont disposées en une rangée, une surface centrale des surfaces de sortie (5.2₁,..., 5.2ₙ) étant parallèle à la surface d'entrée (5.1) et d'autres des surfaces de sortie (5.2₁,..., 5.2ₙ) étant symétriques par rapport à la surface d'entrée (5.2₁,..., 5.2ₙ), de sorte que deux des autres surfaces de sortie (5.2₁,..., 5.2ₙ) se font face symétriquement et forment un angle égal avec la surface centrale des surfaces de sortie (5.2₁,..., 5.2ₙ).

9. Dispositif d'émission selon la revendication 5, **caractérisé en ce que**
le dispositif de rayonnement (1) émet au moins deux faisceaux laser (S₁,..., Sₙ) avec des axes de faisceau (A₁,..., Aₙ) orientés parallèlement l'un à l'autre et que l'élément de déviation (5) présente une surface d'entrée plane (5.1₃) qui est disposée perpendiculairement à un plan tangentiel imaginaire (T) de la coque hémisphérique monocentrique (HK), une surface arrière (5.3) et un nombre de surfaces de sortie planes (5.2₁,..., 5.2ₙ), inclinées les unes par rapport aux autres, qui est égal au nombre de faisceaux laser (S₁,..., Sₙ) émis par le dispositif de rayonnement (1), de sorte que les au moins deux faisceaux laser (S₁,..., Sₙ), lorsqu'ils sont orientés perpendiculairement à la surface d'entrée (5.1₃), sont réfléchis par la surface arrière (5.3) et sont respectivement dirigés sur le centre (MP) par la réfraction sur les surfaces de sortie (5.2₁,..., 5.2ₙ).

10. Dispositif d'émission selon l'une quelconque des revendications 5 à 9, **caractérisé en ce que** l'élément de déviation (5) est formé de manière monolithique dans l'élément de recouvrement (4).
